# EUROPEAN PATENT APPLICATION

(11) **EP 4 199 124 A1**
(43) Date of publication of application: **21.06.2023**
(21) Application number: 21737328.1
(22) Date of filing: 11.05.2021
(51) Int. Cl.: H01L 31/18, H01L 31/032, H01L 31/0216

(54) **METHOD FOR MANUFACTURING PEROVSKITE THIN FILM HAVING WIDE BANDGAP, PEROVSKITE THIN FILM MANUFACTURED THEREBY, AND SOLAR CELL COMPRISING SAME**

(30) Priority: 13.08.2020 KR 20200101527
(71) Applicant: Seoul National University R&DB Foundation, Seoul 08826 (KR)
(72) Inventor: KIM, Jin Young, Seoul 06288 (KR); JI, Su Geun, Ulsan 44500 (KR); PARK, Ik Jae, Seoul 08819 (KR); AHN, You Jin, Suncheon-si, Jeollanam-do 57945 (KR)
(74) Representative: Potter Clarkson
(86) International application number: PCT/KR2021/005845
(87) International publication number: WO 2022/035020

(57) **Abstract**

A method for manufacturing a perovskite thin film having a wide band gap according to an embodiment of the present invention manufactures a perovskite thin film having an ABX₃ structure, while fundamentally preventing a halide separation by allowing an X site to be pure iodine, and achieving a wide band gap exceeding 1.6 eV by allowing a part of an A site to be composed of cesium. At this time, by allowing cations having a large ion size to be the other part of the A site, a problem in that the stability and performance of a device using a perovskite thin film manufactured at room temperature are lowered due to the small ion size of cesium is solved. Particularly, by adding a compound of monovalent cations and chlorine (for example, Methylammonium chloride (MACl)) as an additive to a precursor composition of a perovskite material during a manufacturing process, the tolerance factor of Cesium-rich perovskite generated immediately after antisolvent treatment is increased to about ~0.9, so that the difference with the tolerance factor (~1.0) of a cesium-decifit solute to be precipitated in a subsequent heat treatment process is reduced to prevent the formation of a secondary phase.

## Description

### TECHNICAL FIELD

The present invention relates to a method for manufacturing a perovskite thin film having a wide band gap, a perovskite thin film manufactured thereby, and a solar cell including the same.

### BACKGROUND ART

In order to solve global environmental problems caused by the depletion of fossil energy and the use thereof, research has been actively conducted on renewable, clean alternative energy sources such as solar energy, wind power, and water power. Among the above, the interest in solar cells which directly convert sunlight into electrical energy is increasing greatly. A solar cell refers to a cell which generates a current voltage using the photovoltaic effect of absorbing light energy from sunlight to generate electrons and holes.

A perovskite material is a material with high interest as a next-generation solar cell material. Typically, the band gap of a perovskite material is about 1.5 to 1.6 eV, and theoretically, the perovskite material needs to have a wider wide band gap for the high efficiency of perovskite/silicon tandem.

Currently, various attempts have been made to widen the band gap of a perovskite material having a ABX₃ structure. The most widely used method is to substitute a part of iodine (I) of an X site with bromine (Br). However, bromine-iodine mixed perovskite has a fatal reliability problem due to a halide separation phenomenon in which an iodine-rich phase and a bromine-rich phase are separated in a perovskite material in an environment in which light is irradiated.

Therefore, in order to widen the band gap of the perovskite material having a ABX₃ structure, a method for substituting some or all of the compositions of an A site with cesium (Cs) has been proposed other than the method for substituting a part of iodine (I) of the X-site with bromine (Br). In the case of CsPbI₃ in which the A site is composed of 100% cesium, there is an advantage in that the band gap may be widened up to 1.73 eV. However, there is a problem with cesium in that it is unstable at room temperature due to its small ion size. In order to increase the band gap while overcoming the thermodynamic instability in which cesium is unstable at room temperature, large organic cations should be added simultaneously without substituting all of the A site with Cs. However, in this process, due to the difference between the tolerance factor (~0.8) of cesium-rich perovskite and the tolerance factor (~1.0) of a cesium-deficit solute, a secondary phase is generated, which adversely affects stability and performance.

Therefore, there is a need for a new method capable of manufacturing a perovskite thin film having a wide band gap exceeding 1.6 eV while solving the above-mentioned problems.

### DISCLOSURE OF THE INVENTION

### TECHNICAL PROBLEM

An object of the present invention is to propose a method for manufacturing a perovskite thin film, the method which uses a perovskite material having an ABX₃ structure, but has no halide separation problem, and which substitutes cesium for an A site, thereby having a wide band gap exceeding 1.6 eV, but solves the problem in that cesium is unstable at room temperature due to its small ion size.

Meanwhile, other objects of the present invention that are not specified will be further considered within the scope that can be easily derived from the following detailed description and the effects thereof.

### TECHNICAL SOLUTION

A method for manufacturing a perovskite thin film having a wide band gap according to an embodiment of the present invention to solve the above-mentioned limitations is a method for manufacturing a perovskite thin film having an ABX₃ structure, the method including adding at least one selected from the group consisting of A1Cl, A2Cl, and A3Cl to a precursor composition including A1X, A2X, A3X, and BX₂ (wherein, A1, A2, and A3 are monovalent cations located at the A site, and the ion sizes thereof satisfy A1<A2<A3, and B is lead (Pb) and X is iodine (I)), dissolving the precursor composition added with the additive in a solvent, spin coating the solvent in which the precursor composition is dissolved, while forming a preliminary thin film by dropping an antisolvent during the spin coating, and heat treating the preliminary thin film to manufacture a perovskite thin film having an ABX₃ structure (wherein, A is composed of A1, A2 and A3) .

In an embodiment, A1 may be Cs, A2 may be methylammonium (MA), and A3 may be any one selected from the group consisting of dimethylammonium (DMA), guanidinium (Gua), formamidinium (FA), ethylammonium (EA), and azetidinium (Az), or a mixture thereof.

In an embodiment, the content ratio of A1, A2, and A3 present in the precursor composition and in the additive may be 0.2 to 0.6 : 0.1 to 0.7 : 0.1 to 0.5.

In an embodiment, the solvent may be at least one selected from the group consisting of dimethylformamide (DMF), N-methyl-2- pyrrolidone (NMP), and dimethyl sulfoxide (DMSO).

In an embodiment, the antisolvent may be methyl acetate or ethylacetate.

In an embodiment, remaining Cl included in the additive may be removed during the heat treating.

In an embodiment, the heat treating may be performed at 100 to 120°C for 5 to 20 minutes.

In an embodiment, the perovskite thin film may be Cs_{0.3}MA_{0.5}DMA_{0.2}PbI₃ or Cs_{0.4}MA_{0.3}DMA_{0.3}PbI₃.

In an embodiment, the band gap of the manufactured perovskite thin film may exceed 1.6 eV.

A perovskite thin film according to another embodiment of the present invention to solve the above-mentioned limitations is a perovskite thin film having an ABX₃ structure, wherein A is a monovalent cation composed of A1, A2, and A3, and the ion sizes thereof satisfy A1<A2<A3, and B is lead (Pb) and X is iodine (I)).

In another embodiment, A1 may be Cs, A2 may be methylammonium (MA), and A3 may be any one selected from the group consisting of dimethylammonium (DMA), guanidinium (Gua), formamidinium (FA), ethylammonium (EA), and azetidinium (Az), or a mixture thereof.

In another embodiment, the content ratio of A1, A2, and A3 may be 0.2 to 0.6 : 0.1 to 0.7 : 0.1 to 0.5.

In another embodiment, the perovskite thin film may be Cs_{0.3}MA_{0.5}DMA_{0.2}PbI₃ or Cs_{0.4}MA_{0.3}DMA_{0.3}PbI₃.

In another embodiment, the band gap of the perovskite thin film may exceed 1.6 eV.

In another embodiment, a peak corresponding to a δₒ phase and a peak corresponding to a δₕ phase may not appear in an XRD peak measurement result of the perovskite thin film.

A solar cell according to another embodiment of the present invention to solve the above-mentioned limitations is a solar cell including a light absorbing layer, wherein the light absorbing layer has an ABX₃ structure, and A is a monovalent cation composed of A1, A2, and A3, and the ion sizes thereof satisfy A1<A2<A3, and B is lead (Pb) and X is iodine (I).

In another embodiment, the light absorbing layer may further include a silicon thin film, and the perovskite thin film and the silicon thin film may form a tandem structure.

In another embodiment, the perovskite thin film may be Cs_{0.3}MA_{0.5}DMA_{0.2}PbI₃ or Cs_{0.4}MA_{0.3}DMA_{0.3}PbI₃.

In another embodiment, a peak corresponding to a δₒ phase and a peak corresponding to a δₕ phase may not appear in an XRD peak measurement result of the perovskite thin film.

### ADVANTAGEOUS EFFECTS

A method for manufacturing a perovskite thin film having a wide band gap according to an embodiment of the present invention manufactures a perovskite thin film having an ABX₃ structure, while fundamentally preventing a halide separation by allowing an X site to be pure iodine, and achieving a wide band gap exceeding 1.6 eV by allowing a part of an A site to be composed of cesium. At this time, by allowing cations having a large ion size to be the other part of the A site, a problem in that the stability and performance of a device using a perovskite thin film manufactured at room temperature are lowered due to the small ion size of cesium is solved. Particularly, by adding a compound of monovalent cations and chlorine (for example, Methylammonium chloride (MACl)) as an additive to a precursor composition of a perovskite material during a manufacturing process, the tolerance factor of Cesium-rich perovskite generated immediately after antisolvent treatment is increased to about ~0.9, so that the difference with the tolerance factor (~1.0) of a cesium-decifit solute precipitated in a subsequent heat treatment process is reduced to prevent the formation of a secondary phase.

Meanwhile, although not explicitly stated herein, it should be understood that effects described in the following specification that are expected by the technical features of the present invention and their provisional effects are treated as described in the specification of the present invention.

### BRIEF DESCRIPTION OF THE DRAWINGS

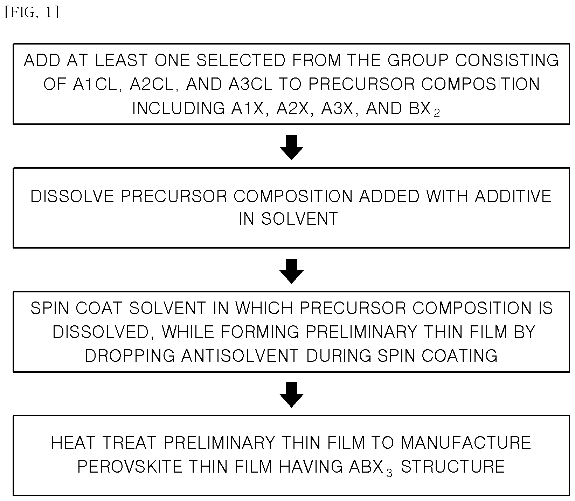

FIG. 1 is a schematic flow chart of a method for manufacturing a perovskite thin film according to an embodiment of the present invention;

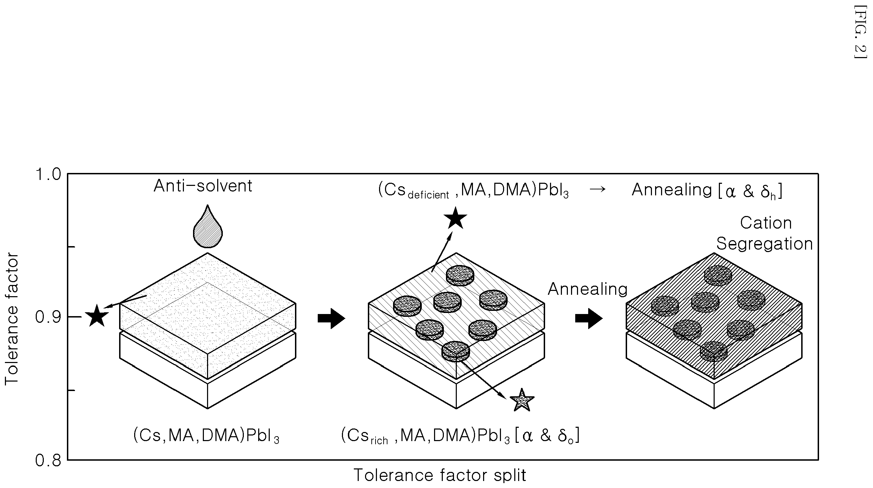

FIG. 2 is a reference diagram for describing a process in which a secondary phase is formed due to the difference between the tolerance factor of a solute precipitated immediately after antisolvent treatment and the tolerance factor of a solute precipitated during a subsequent heat treatment process in manufacturing a perovskite thin film containing Cs;

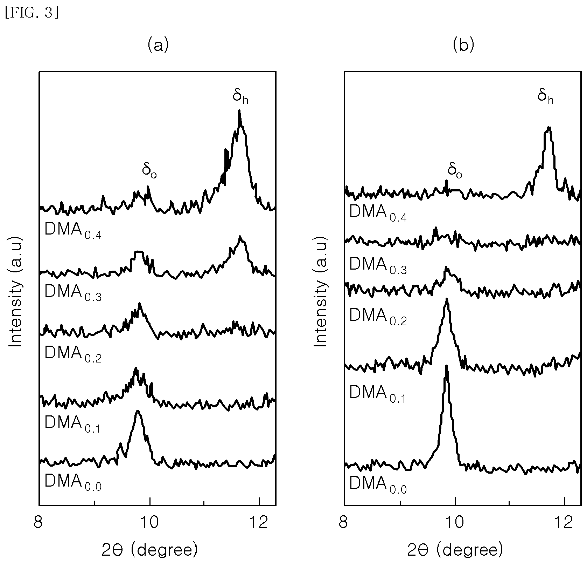

FIG. 3 are XRD measurement results for confirming the presence or absence of a secondary phase according to the amount of DMA at an A site, and the DMA is used as a cation having a large ion size, and are XRD measurement results of (a) when an MACl additive is not used in a manufacturing process, and (b) when an MACl additive is used in a manufacturing process;

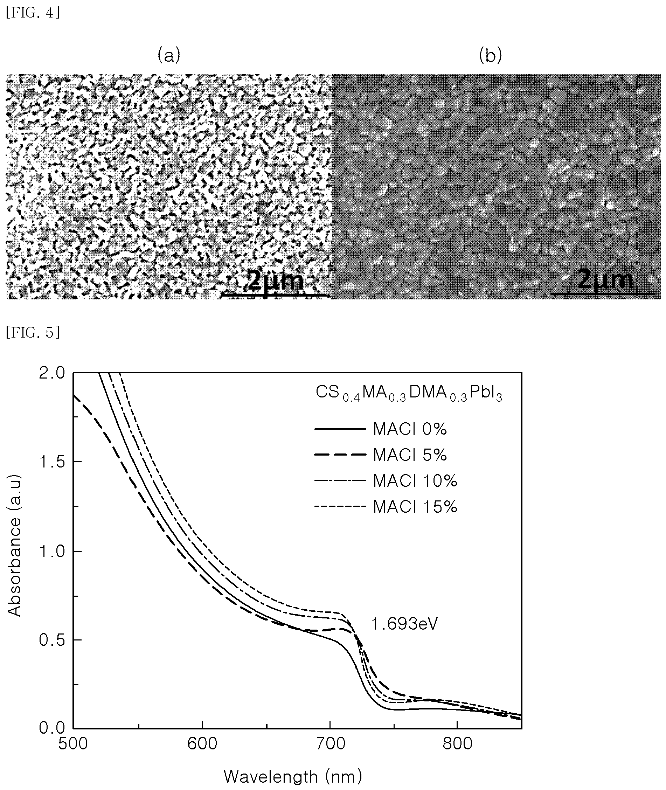

FIG. 4 are SEM images photographed (a) when an MACl additive is not used in a manufacturing process, and (b) when an MACl additive is used in a manufacturing process, when the amount of DMA at an A site is 30% and the DMA is used as a cation having a large ion size;
FIG. 5 shows the measurement of absorbance according to the content of an MACl additive in a process of manufacturing Cs_{0.4}MA_{0.3}DMA_{0,3}PbI₃;

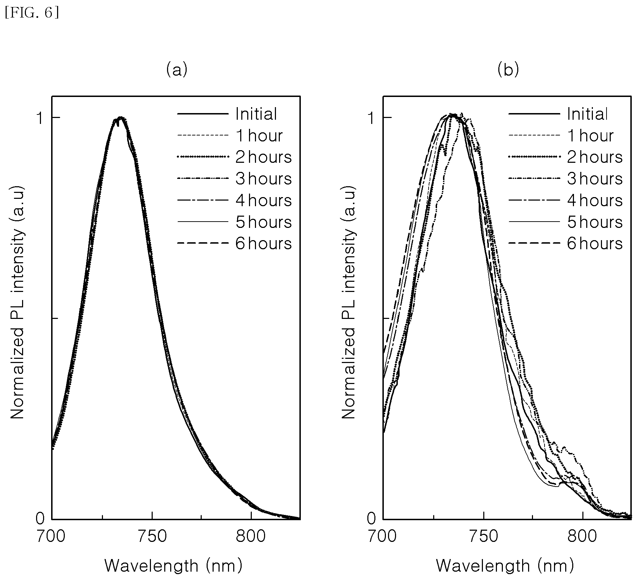

FIG. 6 shows photoluminescence spectra measured to evaluate the occurrence of halide separation in a light irradiation environment, the photoluminescence spectra measured according to the light irradiation time of (a) when an X site has the composition of pure iodine, and (b) when an X site has the composition of bromine and iodine;

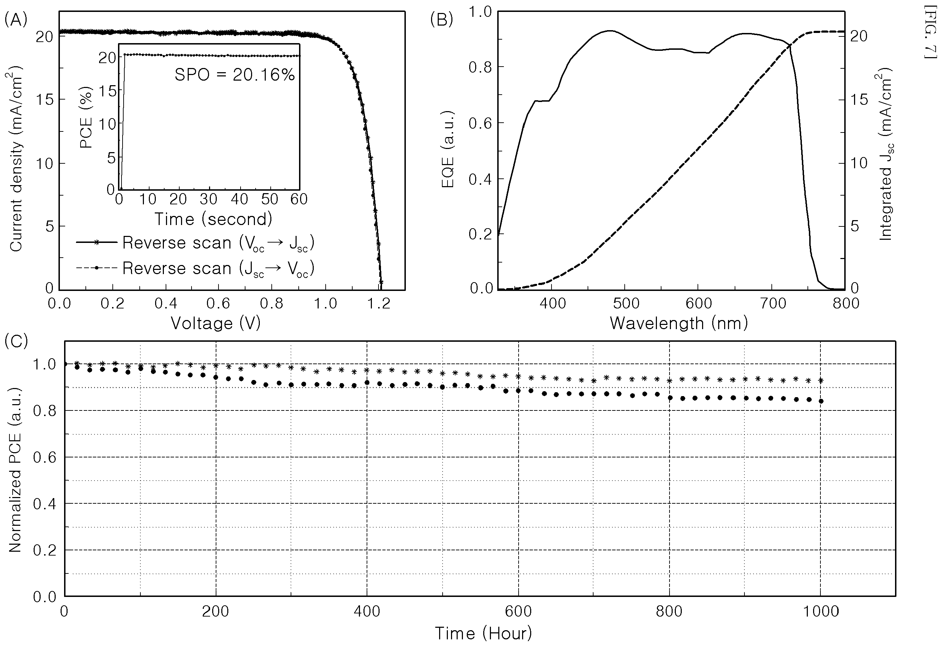

FIG. 7 are (a) a measurement result of a J-V curve of a solar device manufactured using Cs_{0.3}MA_{0.5}DMA_{0.2}PbI₃ prepared using an MACl additive as a light absorbing layer, (b) EQE and integrated J_{sc} measurement results, and (c) a long-term stability measurement result; and

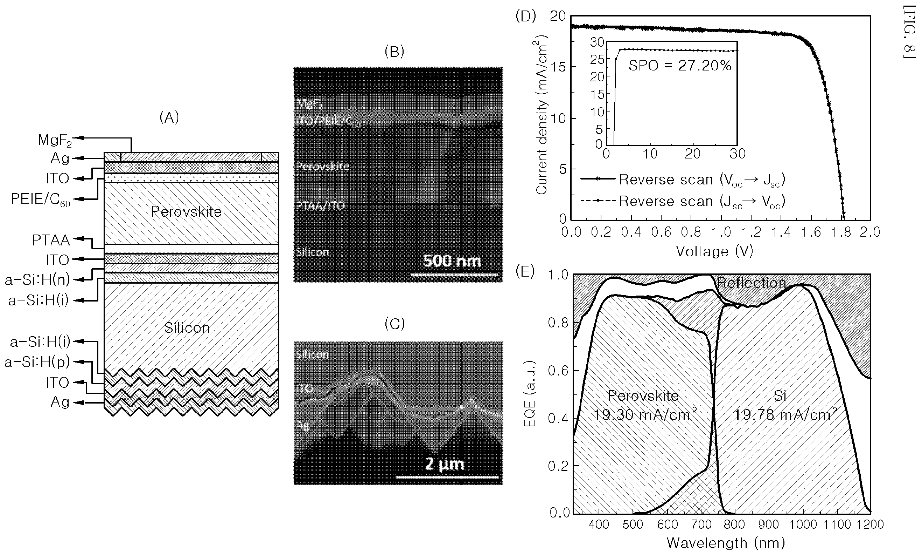

FIG. 8 are (a) a schematic structural diagram of a solar device having a tandem structure of perovskite and silicon of the composition of Cs_{0.3}MA_{0.5}DMA_{0.2}PbI₃ prepared using an MACl additive, (b) an FE-SEM image of a tandem perovskite layer, (c) an FE-SEM image of a cross-section of a textured portion of a rear surface of a tandem, (d) a J-V curve measurement result, and (e) an EQE-(1-R%) spectrum measurement result.

The accompanying drawings are exemplified by reference for an understanding of the technical idea of the present invention, and the scope of the present invention is not limited thereto.

### MODE FOR CARRYING OUT THE INVENTION

Hereinafter, with reference to the drawings, the configuration of the present invention guided by various embodiments of the present invention, and effects resulting from the configuration will be described. In describing the present invention, detailed descriptions of related known functions will be omitted when it is determined that the detailed descriptions may unnecessarily obscure the gist of the present invention that is apparent to those skilled in the art.

FIG. 1 is a schematic flow chart of a method for manufacturing a perovskite thin film according to an embodiment of the present invention.

Referring to FIG. 1, a method for manufacturing a perovskite thin film according to an embodiment of the present invention includes adding at least one selected from the group consisting of A1Cl, A2Cl, and A3Cl to a precursor composition including A1X, A2X, A3X, and BX₂ (wherein, A1, A2, and A3 are monovalent cations located at the A site, and the ion sizes thereof satisfy A1<A2<A3, and B is lead (Pb) and X is iodine (I)), dissolving the precursor composition added with the additive in a solvent, spin coating the solvent in which the precursor composition is dissolved, while forming a preliminary thin film by dropping an antisolvent during the spin coating, and heat treating the preliminary thin film to manufacture a perovskite thin film having an ABX₃ structure (wherein, A is composed of A1, A2 and A3).

Theoretically, in order to maximize the efficiency in a perovskite-silicon tandem solar device, the band gap of perovskite used should be widened. The band gap of a high-efficiency perovskite composition typically used is only about 1.5 to 1.6 eV. Therefore, a perovskite thin film having a wide band gap exceeding 1.6 eV is needed.

Typically, as a method of increasing the band gap in order to use perovskite in a tandem, there is a method of substituting a portion of an X site iodine anion in an ABX₃ perovskite structure with bromine, but the method has a halide separation problem. In addition, there is a method of using cesium for an A site, but the method has a problem in that commercialization is substantially impossible because a secondary phase is generated due to small ion size of cesium and non-uniformity of cations caused by a precipitation behavior of cesium different from that of common organic cations during a manufacturing process.

The method for manufacturing a perovskite thin film according to an embodiment of the present invention solves the above-mentioned limitations and also implements a wide band gap exceeding 1.6 eV.

First, a step of adding at least one selected from the group consisting of A1Cl, A2Cl, and A3Cl to a precursor composition including A1X, A2X, A3X, and BX₂ is performed.

A1, A2, and A3 refer to monovalent cations located at an A-site of a perovskite material having an ABX₃ structure. The manufacturing method of an embodiment of the present invention in characterized in that A1, A2, and A3 have different ion sizes from each other. For example, the ion sizes of A1, A2, A3 may be A1<A2<A3.

At this time, A1 is preferably cesium (Cs). As described above, when cesium (Cs) is substituted for the A site, the band gap of a perovskite thin film to be manufactured becomes wide, but there is a problem in that stability at room temperature is significantly decreased due to the small ion size of cesium.

Therefore, in the method for manufacturing a perovskite thin film according to an embodiment of the present invention, a mid-sized monovalent cation A2, and a monovalent cation A3 having an ion size bigger than that of A2 are substituted for the A site, so that the problem caused by the small ion size of cesium is solved. Particularly, the ratio of cesium occupying the A site is controlled to be 20% or greater, preferably 30% or greater to achieve a band gap of greater than 1.6 eV of a perovskite thin film to be manufactured.

However, when various cations are used as described above, cesium ions tend to be precipitated before other cations during a thin film forming process, which causes a new problem. That is, if there is antisolvent treatment performed during a manufacturing process, due to the difference between the tolerance factor (~0.8) of cesium-rich perovskite, which is a composition precipitated first, and the tolerance factor (~1.0) of a cesium-deficit solute precipitated during a subsequent heat treatment process, a hexagonal (δₕ) phase or an orthorhombic (δₒ) phase is generated as a secondary phase, so that it is not possible to properly form a thin film.

The following will be described in detail with reference to FIG. 2. Cesium cations are characterized in having a lower degree of solubility than other organic cations A2 and A3 to a solution in which a precursor composition is dissolved. That is, there is a difference in precipitation tendency between cesium cations and A2 or A3. Relatively, it is harder for cesium ions to remain in a perovskite solution and be present therein as ions than for other organic cations. Therefore, when an antisolvent is added to manufacture a perovskite thin film, cesium ions are selectively precipitated more than other organic cations immediately after the addition of the antisolvent. At this time, there is a problem in that cesium-rich precipitates, which are precipitated first, are partly precipitated not only in a perovskite phase (α) but also in an orthorhombic phase (δₒ). This is a phenomenon caused by a low tolerance factor of the cesium-rich precipitates, which is about 0.8. During a heat treatment process of a perovskite thin film formed thereafter, cesium-decifit solutes yet to be precipitated are precipitated. Since cesium has been first precipitated in a large amount, other cations have a relatively large tolerance factor (about ~1.0) . During the process, the above solutes grow into perovskite crystals or nucleate into other phases. However, as described above, due to the difference between the tolerance factor (~0.8) of the cesium-rich perovskite and the tolerance factor (~1.0) of the cesium-deficit solutes, the solutes are partly precipitated through the growth into a perovskite phase, but at the same time, the nucleation and growth of a hexagonal (δₕ) phase due to the difference in tolerance factor simultaneously occurs. The presence of such secondary phases adversely affects the stability and performance of a device using the perovskite thin film.

The method for manufacturing a perovskite thin film according to an embodiment of the present invention is characterized by adding a compound of monovalent cations and chlorine as an additive to a precursor composition in order to solve the above-described problem caused by the difference in precipitation tendency between cesium and other monovalent cations.

Similar to cations, the degree of solubility of anions with respect to a perovskite solution of anions increases in the order of chlorine (Cl), bromine (Br), and iodine (I). That is, in a process of forming a perovskite thin film, chlorine is first precipitated, and then bromine and iodine are sequentially precipitated. When an antisolvent is added to manufacture a perovskite thin film, cesium ions are selectively precipitated more than other organic cations immediately after the addition of the antisolvent. At the time of precipitation of cesium ions by the addition of the antisolvent, when chlorine or bromine which is precipitated before iodine is contained in a solution, chlorine or bromine is precipitated before iodine. That is, an anion part of a cesium-rich precipitate precipitated when an antisolvent is added becomes bromine-rich or chlorine-rich. Accordingly, the tolerance factor of the cesium-rich precipitate is increased from about 0.8 to about 0.9 due to the radius of the anion reduced. In the end, by using an additive, the amount of precipitation in an orthorhombic phase, which is generated when an additive is not used, may be reduced to allow more pure precipitation into a perovskite phase. Also, since bromine and chlorine are mostly precipitated as the anion part of the cesium-rich precipitate, the tolerance factor of a remaining cesium-decifit solute yet to be precipitated before heat treatment is maintained. Eventually, the difference between the tolerance factor value of precipitated cesium-rich perovskite and the tolerance factor value of the cesium-decifit solutes yet to be precipitated is reduced, so that during a heat treatment process, the nucleation of a hexagonal (δₕ) phase is reduced, and the growth into perovskite crystals mostly occurs. In conclusion, the generation of a secondary phase of a perovskite thin film is prevented when an additive is used, so that a high-quality perovskite thin film may be manufactured.

However, when an additive containing bromine is used, there is a problem as follows. When an additive containing bromine is used, there is a problem in that bromine is included in the crystal structure of an iodine matrix when a perovskite thin film is completed through heat treatment. That is, there is an halide separation problem caused by bromine. Bromine is included in the crystal structure of an iodine matrix because there is no significant anion radius difference between iodine and bromine. In contrast, when an additive containing chlorine is used, even though chlorine effectively suppresses the generation of a secondary phase during the formation of a perovskite thin film, there is no chlorine remaining after heat treatment. This is because chlorine is not stably present in an iodine matrix due to the difference in ion radius between iodine and chlorine, so that chlorine is all evaporated to the outside during a heat treatment process. That is, only when an additive containing chlorine is used, it is possible to manufacture a pure iodine-based perovskite thin film having a wide band gap. The method for manufacturing a perovskite thin film having a wide band gap according to an embodiment of the present invention uses a high proportion of Cs, and uses iodine (I) and chlorine (Cl) anions, and thus, is an effective method to address limitations regarding the halide separation problem and the secondary phase generation problem which occur when a perovskite thin film is typically manufactured using iodine (I) and bromine (Br). Furthermore, when an additive containing chlorine and an additive containing bromine are used together, bromine serves as a bridge to allow all of iodine, bromine, and chlorine to be present within a grid, so that it is not possible to obtain a pure iodine-based perovskite thin film.

Meanwhile, an additive may use at least one among A1Cl, A2Cl, and A3Cl as an anion source, and chlorine contained therein may be sublimated to the outside together with A2 which serves as a filler included in the basic composition. Particularly, MACl is a highly sublimable material, and in particular, chlorine (Cl), which is not stable in an iodine matrix, is easily sublimated to the outside in the form of MACl.

A1, A2, and A3 refer to monovalent cations located at an A site of a perovskite material having an ABX₃ structure. A1 may be Cs, A2 may be methylammonium (MA), and A3 may be any one selected from the group consisting of dimethylammonium (DMA), formamidinium (FA), guanidinium (Gua), ethylammonium (EA), and azetidinium (Az), or a mixture thereof. Also, B may be lead (Pb), and X may be iodine (I).

It is preferable that the content ratio of A1, A2, and A3 present in the precursor composition and in the additive is 0.2 to 0.6 : 0.1 to 0.7 : 0.1 to 0.5. When A1 (cesium) is contained in less than 0.2, it is not possible to increase the band gap to about 1.7 eV. When greater than 0.6, the low solubility of cesium is problematic. Also, when the ratio of A1 : A3 is 0.2 to 0.6 : 0.1 to 0.5, the problem caused by the small ion size of cesium is compensated by A3 whose ion size is large, so that stability is increased. Specifically, at the A site, when the ratio of cesium is 20%, the ratio of A3 may be 10 to 30%, and when the ratio of cesium is 30%, the ratio of A3 may be 10 to 40%. When the ratio of cesium is 40 to 50%, the ratio of A3 may be 20 to 60%, and when the ratio of cesium is 60%, the ratio of A3 may be 20 to 40%.

Meanwhile, the content of the additive may be 5 to 25 mol% based on the total of the precursor composition and the additive. Then amount of then additive may be determined in proportion to the amount of cesium included in perovskite.

After an additive is added to a precursor composition including A1X, A2X, A3X, and BX₂, the precursor composition added with the additive is dissolved in a solvent. The solvent may be at least one selected from the group consisting of dimethylformamide (DMF), N-methyl-2-pyrrolidone (NMP), and dimethyl sulfoxide (DMSO).

After the precursor composition and the additive are dissolved in the solvent, the solvent in which the precursor composition is dissolved is subjected to spin coating. At this time, during the spin coating, an antisolvent is dropped to form a preliminary thin film. As the antisolvent, methyl acetate or ethylacetate may be used.

After the preliminary thin film is formed, a step of heat treating the preliminary thin film at 100 to 120°C for 5 to 20 minutes to grow a perovskite phase, and simultaneously removing remaining chlorine is performed to manufacture a perovskite thin film.

The perovskite thin film manufactured by the method for manufacturing a perovskite thin film according to an embodiment of the present invention may be Cs_{0.3}MA_{0.5}DMA_{0.2}PbI₃ or Cs_{0.4}MA_{0.3}DMA_{0.3}PbI₃.

### Example

In order to manufacture a perovskite thin film, a precursor composition and an additive were prepared. The precursor composition was composed of CsI, MAI, DMAI, and PbI₂, and MACl was used as the additive. The content of the precursor composition and the content of the additive were adjusted according to the composition of a perovskite thin film to be manufactured.

The prepared precursor composition was dissolved in a solvent in which DMF and NMP were mixed at a volume ratio of 4:1. The solvent was spin coated for 22 seconds at a speed of 3000 rpm to form a preliminary thin film. At this time, 50 µl of methyl acetate was added as an antisolvent 17 seconds after the start of the spin. After the spin coating was finished, the prepared thin film was heat treated for 10 minutes at 100°C to manufacture a perovskite thin film.

In order to manufacture Cs_{0.3}MA_{0.5}DMA_{0.2}PbI₃, 0.36 mM of CsI, 0.60 mM of MAI, 0.24 mM of DMAI, and 1.2 mM of PbI₂ were dissolved in 0.8 mL of DMF and 0.2 mL of NMP, and as the MACl additive, 0.12 mM of MACl having 10 mol% was used. In order to manufacture Cs_{0.4}MA_{0.3}DMA_{0.3}PbI₃, 0.48 mM of CsI, 0.36 mM of MAI, 0.36 mM of DMAI, and 1.2 mM of PbI₂ were dissolved in 0.8 mL of DMF and 0.2 mL of NMP, and as the MACl additive, 0.18 mM of MACl having 15 mol% was used. In each experiment, only the composition corresponding to a variable in the composition for manufacturing Cs_{0.3}MA_{0.5}DMA_{0.2}PbI₃ or Cs_{0.4}MA_{0.3}DMA_{0.3}PbI₃ was changed to manufacture a perovskite thin film.

The results of experiments conducted using the perovskite thin films manufactured by the method described in the above example will be described below.

FIG. 3 are XRD measurement results for confirming the presence or absence of a secondary phase according to the amount of DMA at an A site, and the DMA is used as a cation having a large ion size, and are XRD measurement results of (a) when an MACl additive is not used in a manufacturing process, and (b) when an MACl additive is used in a manufacturing process, and FIG. 4 are SEM images photographed (a) when an MACl additive is not used in a manufacturing process, and (b) when an MACl additive is used in a manufacturing process, when the amount of DMA at an A site is 30% and the DMA is used as a cation having a large ion size.

Referring to FIG. 3(a) and FIG. 4(a), when an MACl additive is not used in a manufacturing process, the peak intensity of an orthorhombic phase (δₒ) gradually decreases with the increase in DMA. However, it can be seen that the orthorhombic phase is clearly present in all intervals, and it can be seen that the orthorhombic phase cannot be removed by simply substituting DMA whose size is large. Rather, when an excessive amount of DMA cations are added, it can be seen that a hexagonal phase (δₕ) is formed. On the contrary, referring to FIG. 3(b) and FIG. 4(b), when 15 mol% of the MACl additive is used in the manufacturing process, it can be confirmed that no secondary phase is detected when the ratio of DMA occupying the A site is 0.3.

FIG. 5 shows the measurement of absorbance according to the content of an MACl additive in a process of manufacturing Cs_{0.4}MA_{0.3}DMA_{0,3}PbI₃.

Referring to FIG. 5, it can be confirmed that as the content of the MACl additive increases, the slope absolute value of a graph at a wavelength of 700 to 750 nm increases, which means that a higher quality perovskite thin film is formed by the MACl additive. Meanwhile, it was confirmed that the band gap of a perovskite thin film was 1.693 eV when the content of the MACl additive was 15 mol%.

FIG. 6 shows photoluminescence spectra measured to evaluate the occurrence of halide separation in a light irradiation environment, the photoluminescence spectra measured according to the light irradiation time of (a) when an X site has the composition of pure iodine, and (b) when an X site has the composition of bromine and iodine.

Referring to FIG. 6, when the X site has the composition of pure iodine, there is no change in the photoluminescence spectrum even after irradiation time has passed. However, when the X site has the composition of bromine and iodine, it can be seen that there is a rapid change in the photoluminescence spectrum due to halide separation. Particularly, it can be confirmed that there is a luminescent peak (~800 nm) of an iodine-rich phase generated by the halide separation. That is, it can be seen that the perovskite thin film manufactured by the manufacturing method of the present invention has significantly higher stability.

FIG. 7 are (a) a measurement result of a J-V curve of a solar device manufactured using Cs_{0.3}MA_{0.5}DMA_{0.2}PbI₃ prepared using an MACl additive as a light absorbing layer, (b) EQE and integrated J_{sc} measurement results, and (c) a long-term stability measurement result. A solar cell according to another example of the present invention uses a perovskite thin film (whose band gap is about 1.69 eV) of the composition of Cs_{0.3}MA_{0.5}DMA_{0.2}PbI₃ as a light absorbing layer, and the structure thereof is a p-i-n inverted structure composed of glass/indium tin oxide (ITO)/PTAA/perovskite thin film/C₆₀/polyethyleneimine(PEIE)/Ag. As a comparative example, a perovskite thin film of the composition of MAPbI_{2.55}Br_{0.45} having a band gap similar to that of the perovskite thin film of the Cs_{0.3}MA_{0.5}DMA_{0.2}PbI₃ composition was used as a light absorbing layer. Referring to FIG. 7, using the solar cell according to another example of the present invention, it was possible to achieve the power conversion efficiency of 20%, the highest efficiency reported to date, in a solar cell using a pure iodine-based perovskite thin film having a wide band gap. In addition, the stability of the comparative example (orange dots in FIG. 7) gradually decreases as time passes, whereas the stability of the embodiment (blue dots in FIG. 7) is firmly maintained.

FIG. 8 are (a) a schematic structural diagram of a solar device having a tandem structure of perovskite and silicon of the composition of Cs_{0.3}MA_{0.5}DMA_{0.2}PbI₃ prepared using an MACl additive, (b) an FE-SEM image of a tandem perovskite layer, (c) an FE-SEM image of a cross-section of a textured portion of a rear surface of a tandem, (d) a J-V curve measurement result, and (e) an EQE-(1-R%) spectrum measurement result. When the perovskite thin film of the present invention is used together with silicon to form a tandem structure, the efficiency of a solar cell is 27% or greater.

Table 1 below shows the results of measuring the performance of the solar cell of another example.

**[Table 1]**

| | J_{sc} (mA/cm²) | V_{oc} (V) | PCE (%) | Fill factor (%) |
|---|---|---|---|---|
| Opaque cell (reverse scan), 0.14 cm² | 20.30 | 1.21 | 20.18 | 82.1 |
| Opaque cell (forward scan), 0.14 cm² | 20.30 | 1.21 | 20.15 | 82.0 |
| Tandom cell (reverse scan), 1.0 cm² | 18.91 | 1.82 | 27.35 | 79.5 |
| Tandom cell (forward scan), 1.0 cm² | 19.04 | 1.83 | 27.17 | 78.0 |

The scope of protection of the present invention is not limited to the description and expression of the embodiments explicitly described above. In addition, it should be added once again that the scope of protection of the present invention may not be limited due to obvious changes or substitutions in the technical field to which the present invention pertains.

## Claims

1. A method for manufacturing a perovskite thin film having an ABX₃ structure, the method comprising:
adding at least one selected from the group consisting of A1Cl, A2Cl, and A3Cl to a precursor composition including A1X, A2X, A3X, and BX₂ (wherein, A1, A2, and A3 are monovalent cations located at the A site, and the ion sizes thereof satisfy A1<A2<A3, and B is lead (Pb) and X is iodine (I));
dissolving the precursor composition added with the additive in a solvent;
spin coating the solvent in which the precursor composition is dissolved, while forming a preliminary thin film by dropping an antisolvent during the spin coating; and
heat treating the preliminary thin film to manufacture a perovskite thin film having an ABX₃ structure (wherein, A is composed of A1, A2 and A3).

2. The method of claim 1, wherein A1 is Cs, A2 is methylammonium (MA), and A3 is any one selected from the group consisting of dimethylammonium (DMA), guanidinium (Gua), formamidinium (FA), ethylammonium (EA), and azetidinium (Az), or a mixture thereof.

3. The method of claim 1, wherein the content ratio of A1, A2, and A3 present in the precursor composition and in the additive is 0.2 to 0.6 : 0.1 to 0.7 : 0.1 to 0.5.

4. The method of claim 1, wherein the solvent is at least one selected from the group consisting of dimethylformamide (DMF), N-methyl-2- pyrrolidone (NMP), and dimethyl sulfoxide (DMSO).

5. The method of claim 1, wherein the antisolvent is methyl acetate or ethylacetate.

6. The method of claim 1, wherein remaining Cl included in the additive is removed during the heat treating.

7. The method of claim 1, wherein the heat treating is performed at 100 to 120°C for 5 to 20 minutes.

8. The method of claim 1, wherein the manufactured perovskite thin film is Cs_{0.3}MA_{0.5}DMA_{0.2}PbI₃ or Cs_{0.4}MA_{0.3}DMA_{0.3}PbI₃.

9. The method of claim 1, wherein the band gap of the manufactured perovskite thin film exceeds 1.6 eV.

10. A perovskite thin film having an ABX₃ structure, wherein A is a monovalent cation composed of A1, A2, and A3, and the ion sizes thereof satisfy A1<A2<A3, and B is lead (Pb) and X is iodine (I).

11. The perovskite thin film of claim 10, wherein A1 is Cs, A2 is methylammonium (MA), and A3 is any one selected from the group consisting of dimethylammonium (DMA), guanidinium (Gua), formamidinium (FA), ethylammonium (EA), and azetidinium (Az), or a mixture thereof.

12. The perovskite thin film of claim 10, wherein the content ratio of A1, A2, and A3 is 0.2 to 0.7 : 0.1 to 0.6 : 0.1 to 0.5.

13. The perovskite thin film of claim 10, wherein the perovskite thin film is Cs_{0.3}MA_{0.5}DMA_{0.2}PbI₃ or Cs_{0.4}MA_{0.3}DMA_{0.3}PbI₃.

14. The perovskite thin film of claim 10, wherein the band gap of the perovskite thin film exceeds 1.6 eV.

15. The perovskite thin film of claim 10, wherein a peak corresponding to a δₒ phase and a peak corresponding to a δₕ phase do not appear in an XRD peak measurement result.

16. A solar cell including a light absorbing layer, the solar cell further comprising a perovskite thin film, wherein the light absorbing layer has an ABX₃ structure, and A is a monovalent cation composed of A1, A2, and A3, and the ion sizes thereof satisfy A1<A2<A3, and B is lead (Pb) and X is iodine (I).

17. The solar cell of claim 16, wherein the light absorbing layer further comprises a silicon thin film, and the perovskite thin film and the silicon thin film form a tandem structure.

18. The solar cell of claim 16, wherein the perovskite thin film is Cs_{0.3}MA_{0.5}DMA_{0.2}PbI₃ or Cs_{0.4}MA_{0.3}DMA_{0.3}PbI₃.

19. The solar cell of claim 16, wherein a peak corresponding to a δₒ phase and a peak corresponding to a δₕ phase do not appear in an XRD peak measurement result.
